(19) Europäisches Patentamt

European Patent Office

Office européen des brevets

(11) **EP 1 413 965 A2**

(12) **EUROPEAN PATENT APPLICATION**

(43) Date of publication:
  **28.04.2004 Bulletin 2004/18**

(51) Int Cl.[7]: **G06F 17/50**

(21) Application number: **03256574.9**

(22) Date of filing: **17.10.2003**

(84) Designated Contracting States:
  **AT BE BG CH CY CZ DE DK EE ES FI FR GB GR HU IE IT LI LU MC NL PT RO SE SI SK TR**
  Designated Extension States:
  **AL LT LV MK**

(30) Priority: **21.10.2002 US 274712**

(71) Applicant: **Hewlett-Packard Development Company, L.P.**
  **Houston, TX 77070 (US)**

(72) Inventors:
  • **Kantorovich, Isaac**
  **Chestnut Hill, MA 02467 (US)**

  • **Drabkin, Victor**
  **Lynn, MA 01902 (US)**
  • **Houghton, Christopher L.**
  **Westborough, MA 01581 (US)**
  • **Tsuk, Michael J.**
  **Arlington, MA 02476-7841 (US)**

(74) Representative: **Powell, Stephen David et al**
  **WILLIAMS POWELL**
  **Morley House**
  **26-30 Holborn Viaduct**
  **London EC1A 2BP (GB)**

(54) **System response testing and modeling**

(57) A method of system response testing and modeling comprises exciting a system (10) with an input having predetermined maximum and minimum input values (14), selecting time pints $t_i$ and $t_j$ in a system response having a plurality of maximum response values at time points $t_i$ and a plurality of minimum response values at time points $t_j$ (16) and generating a maximum worst-case excitation input. The maximum worst-case excitation input has a positive transition from the predetermined minimum input value to the predetermined maximum input value the at each time $(T - t_i)$, and a negative transition from the predetermined maximum input value to the predetermined minimum input value at each time $(T - t_j)$ (18, 20). The method further generates a minimum worst-cast excitation input having a negative transition from the minimum input value to the maximum input value at each time $(T - t_i)$, and a positive transition from the maximum input value to the minimum input value at each time $(T - t_j)$ (18, 22).

*FIG. 2*

```
  12 ─( METHOD )
         │
         ▼
  14 ─┌──────────────────────┐
      │  EXCITE SYSTEM WITH   │
      │   STEP WAVEFORM       │
      └──────────────────────┘
         │
         ▼
  16 ─┌──────────────────────┐
      │ MEASURE TIME = t_0 TO │
      │  t_n FOR ALL MAX AND  │
      │   MIN STEP RESPONSE   │
      └──────────────────────┘
         │
         ▼
  18 ─┌──────────────────────┐
      │ CHOOSE T AND CALCULATE│
      │ (T−t_0), (T−t_1), (T−t_2)... │
      └──────────────────────┘
         │
         ▼
  20 ─┌──────────────────────┐
      │ BUILD STIMULUS FOR MAXIMUM │
      │ SYSTEM RESPONSE FROM MAX   │
      │  AND MIN STEP RESPONSES    │
      └──────────────────────┘
         │
         ▼
  22 ─┌──────────────────────┐
      │ BUILD STIMULUS FOR MINIMUM │
      │ SYSTEM RESPONSE FROM MIN   │
      │  AND MAX STEP RESPONSES    │
      └──────────────────────┘
         │
         ▼
  24 ─( END )
```

## Description

The present invention relates generally to the field of system analysis, and in particular a system and method of system response testing and modeling.

When a system design is under analysis, it is of interest to determine the profile of an input to the system that would lead to the worst-case excitation or response. When the system is under maximum stress, the system behavior can be studied and any undesirable system response can be remedied by design modifications. Systems that can benefit from this analysis include mechanical systems such as automotive suspension system, as well as electronic circuits and systems such as microprocessors.

The ever-increasing clock frequencies and power requirements of microprocessors is putting more demands on the power distribution system. It is critically important that the power distribution system is able to supply the large current demands of the microprocessor at a voltage fixed within certain tolerances. Since the amount of current the microprocessor requires changes in time, both within the period of the microprocessor clock and over many clock cycles, the traditional method for analyzing, modeling and testing the power distribution system has been focused on measuring impedance as a function of frequency. However, focusing on the frequency domain behavior of the power distribution system does not factor in the actual voltage profile of the microprocessor. Such information may be extremely helpful.

In accordance with an embodiment of the present invention, a method comprises exciting a system with a step input having predetermined maximum and minimum input values, selecting time points $t_i$ and $t_j$ in a system response having a plurality of maximum response values at time points $t_i$ and a plurality of minimum response values at time points $t_j$. A maximum worst-case excitation input is then generated. The maximum worst-case excitation input has a positive transition from the predetermined minimum input value to the predetermined maximum input value at each time point $(T - t_i)$, and a negative transition from the predetermined maximum input value to the predetermined minimum input value at each time point $(T - t_j)$.

In accordance with another embodiment of the invention, a method comprises exciting a system with a worst-case excitation input. The worst-case excitation input is generated by selecting time points $t_i$ and $t_j$ in a standard system response to a standard input having a plurality of maximum response values at time points $t_i$ and a plurality of minimum response values at time points $t_j$, the standard input having predetermined minimum and maximum input values. A maximum worst-case excitation input is generated, which has a positive transition from the predetermined minimum input value to the predetermined maximum input value at each time $(T - t_i)$, and a negative transition from the predetermined maximum input value to the predetermined minimum input value at each time $(T - t_j)$. A worst-case system response to the worst-case excitation input is then observed.

In accordance with yet another embodiment of the present invention, a system comprises an interface to a target system, the interface operable to supply input to the target system and receive output from the target system, and a microprocessor coupled to the interface and operable to generate a worst-case excitation input. The worst-case excitation input is generated by: selecting time points $t_i$ and $t_j$ in a standard system response to a standard input having a plurality of maximum response values at time points $t_i$ and a plurality of minimum response values at time points $t_j$, the standard input having predetermined minimum and maximum input values, and generating a maximum worst-case excitation waveform having a positive transition from the predetermined minimum input value to the predetermined maximum input value at each time $(T - t_i)$, and a negative transition from the predetermined maximum input value to the predetermined minimum input value at each time $(T - t_j)$.

In accordance with another embodiment of the present invention, a system comprising a computer-executable medium having encoded thereon a process is provided. The process is operable to excite a system with a step input having predetermined maximum and minimum input values, select time points $t_i$ and $t_j$ in a system response having a plurality of maximum response values at time points ti and a plurality of minimum response values at time points $t_j$, and generate a maximum worst-case excitation input having a positive transition from the predetermined minimum input value to the predetermined maximum input value at each time point $(T - t_i)$, and a negative transition from the predetermined maximum input value to the predetermined minimum input value at each time point $(T - t_j)$.

For a more complete understanding of the present invention, the objects and advantages thereof, reference is now made to the following descriptions taken in connection with the accompanying drawings in which:

FIGURE 1 is a simplified block diagram illustrating an embodiment of the present invention;

FIGURE 2 is a flowchart of an embodiment of a method of determining the maximum system response according to the teachings of the present invention;

FIGURES 3A and 3B are a plots of an exemplary stimulus current and standard voltage response, respectively, according to the teachings of the present invention;

FIGURE 4A is a plot of an exemplary shifting of standard voltage response to construct the stimulus input according to the teachings of the present invention;

FIGURE 4B is a plot of an exemplary system response waveform in reverse time order;

FIGURES 5A through 5D are plots of exemplary shifted voltage responses by $t_i$ or $t_j$ according to the teachings of the present invention;

FIGURE 6 is a plot of an exemplary input stimulus current operable to induce a worst-case voltage response according to the teachings of the present invention;

FIGURE 7 is a plot of an exemplary stimulus current and inverse standard stimulus current according to the teachings of the present invention;

FIGURE 8 is a plot of an exemplary standard voltage response and inverse standard voltage response according to the teachings of the present invention;

FIGURE 9 is a plot of an exemplary worst case minimum voltage and stimulus current according to the teachings of the present invention; and

FIGURE 10 is a plot of an exemplary worst-case maximum voltage and stimulus current according to the teachings of the present invention.

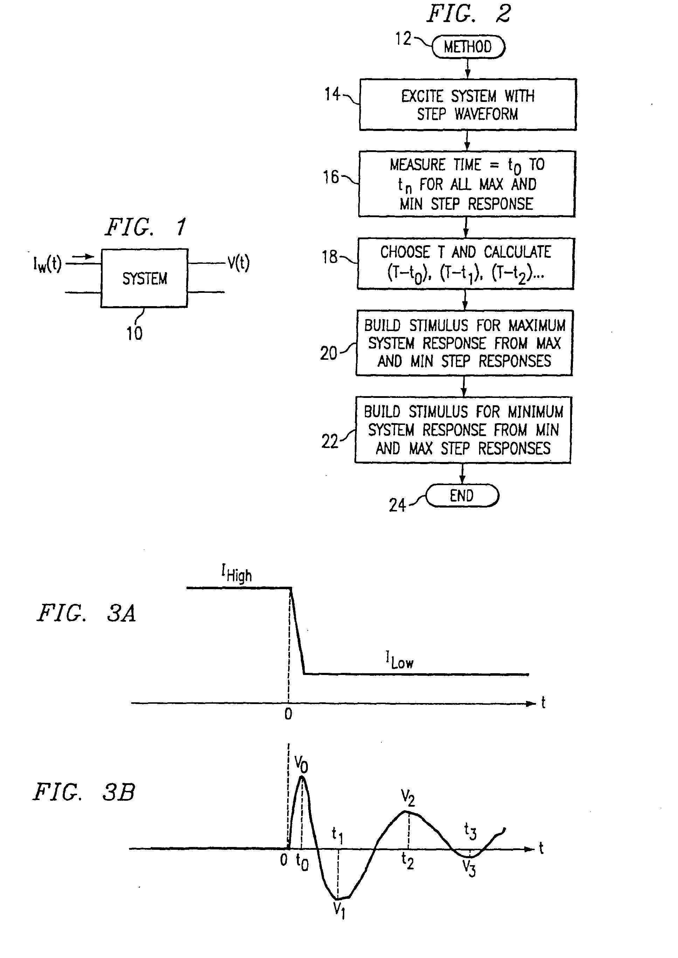

The preferred embodiment of the present invention and its advantages are best understood by referring to FIGURES 1 through 10 of the drawings, like numerals being used for like and corresponding parts of the various drawings.

FIGURE 1 is a simplified block diagram illustrating an embodiment of the present invention. The present invention is applicable to mechanical or electrical systems. A system 10 receives an input as a function of time, such as I(t). Depending on the type of system, the input may be unevenness in the road for an automotive suspension system, for example, or the input current of an electrical/electronic circuit such as a microprocessor. The output or system response to the input as a function of time is V(t). It is of interest to system designers to determine whether system 10 is able to function properly when it is subjected to an input that subjects system 10 to the maximum excitation.

FIGURE 2 is a flowchart of an embodiment of a method 12 of determining the input that would create the maximum system response according to the teachings of the present invention. System 10 is first subject to a step input. FIGURE 3 is an exemplary plot of a step current function having a high current level at t < 0 and at a low current level at t > 0. For mechanical systems, this input may be some standard input or excitation that would generate a measurable system response. Note that there is some finite time during which the time the current level transitions from high to low levels. If the step function is a unit step function, it can be expressed as:

$$I(t) = I_{min} + (I_{max} - I_{min}) * I(t),$$

*where*

$$I(t) = \begin{cases} 0, & t < 0 \\ 1, & t \geq 0, \end{cases}$$

$I_{min}$, $I_{max}$ are minimum and maximum input values. FIGURE 3 further shows a voltage step response to the input current. The points in time, $t_0$, $t_1$, $t_2$, $t_3$,...,where local maxima ($V_0$ and $V_2$, for example, as shown in FIGURE 3) and minima ($V_1$ and $V_3$, for example) responses occur are noted, as shown in blocks 14 and 16 of FIGURE 2. The maxima and minima time occurrences are noted until V(t) tapers to insignificant or unimportant measurements. The occurrences of the maximum points should alternate with the minimum points. In other words, there is only one maximum between any two adjacent minimum points, and there is only one minimum between any two adjacent maximum points.

In block 18, a time, T, is chosen that is equal or later in time than the maximum of time points $t_0$, $t_1$, $t_2$, $t_3$,.... The quantities (T - $t_0$), (T - $t_1$), (T - $t_2$), (T - $t_3$),... are then computed. Because T is greater than the maximum and minimum time points, these quantities are positive. T will be the point in time that is chosen for the occurrence of the worst-case response. The worst-case stimuli is defined as the input that results in maximum or minimum response value. To obtain the stimulus for maximum response value of the system at time moment T, all positive transitions from low-to-high levels of the input at all such time moments (T - $t_i$) are set such that the points $t_i$ are the points of maximum for the transient response. The negative transitions from high-to-low levels of the input are also set for all such time moments (T - $t_j$). Points $t_j$ are the points in time where the local minima occur. To obtain the stimulus for minimum response value of the system at time moment T, all negative transitions from high to low levels of the input at all such time moments (T - $t_i$) are set such that the points $t_i$ are the points of maximum for the transient response. The positive transitions from low to high levels of the input at time (T - $t_j$) are set such that $t_j$ are points of minimum. These two steps are shown in blocks 20 and 22.

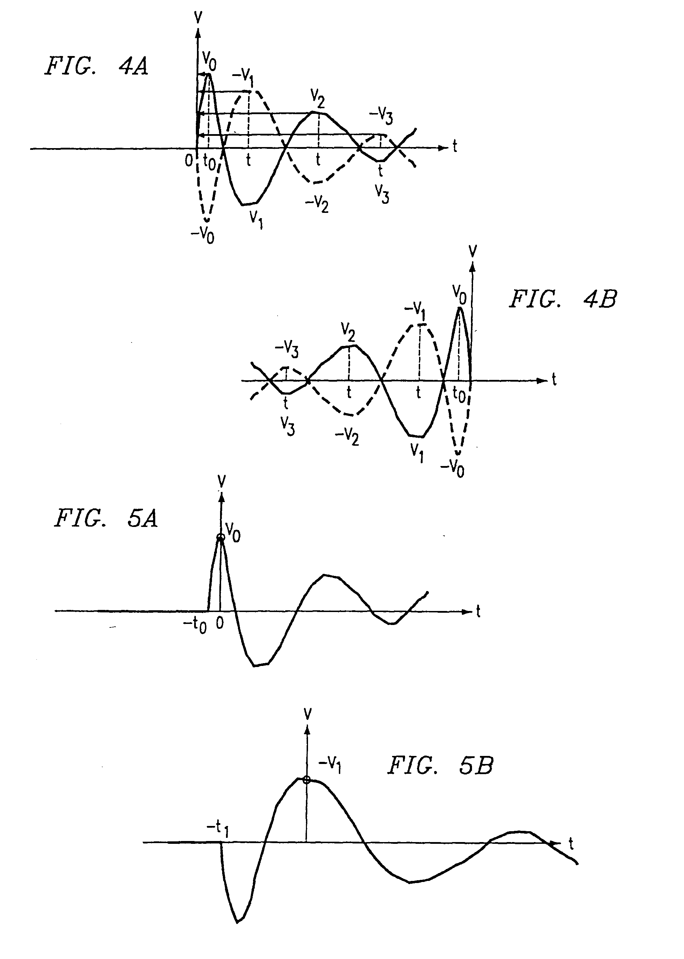

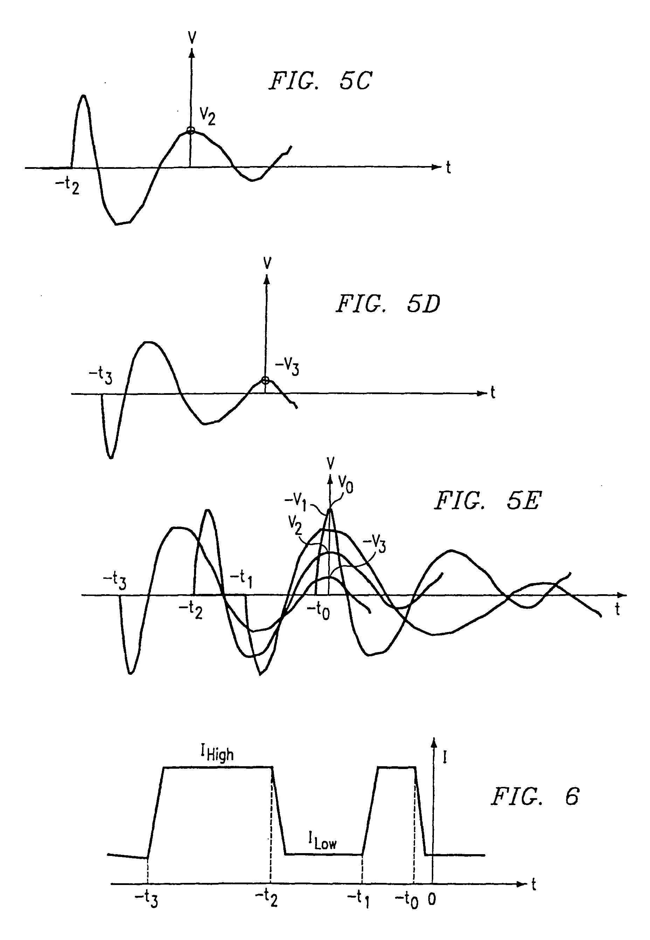

Therefore, the positive and negative voltage step responses can be shifted by shifting the positive and negative input current transients so. that the worst-case voltage response occurs at T, as seen in FIGURE 4. In the example, because at to a low-to-high voltage response transition occurs, a shift of the voltage step response by -to is made, and an input at the maximum input value is determined, as shown in FIGURE 5A. In FIGURE 5B, a shift of the negative or inverse voltage step response by -$t_1$ is made. In FIGURE 5C, a shift of the voltage step response by -$t_2$ is made. In FIGURE 5D, a shift of the negative voltage step response by -$t_3$ is made. FIGURE 5E shows a composite plot of all the shifted voltage step response and negative voltage step responses. At time T, the worst-case system response would occur.

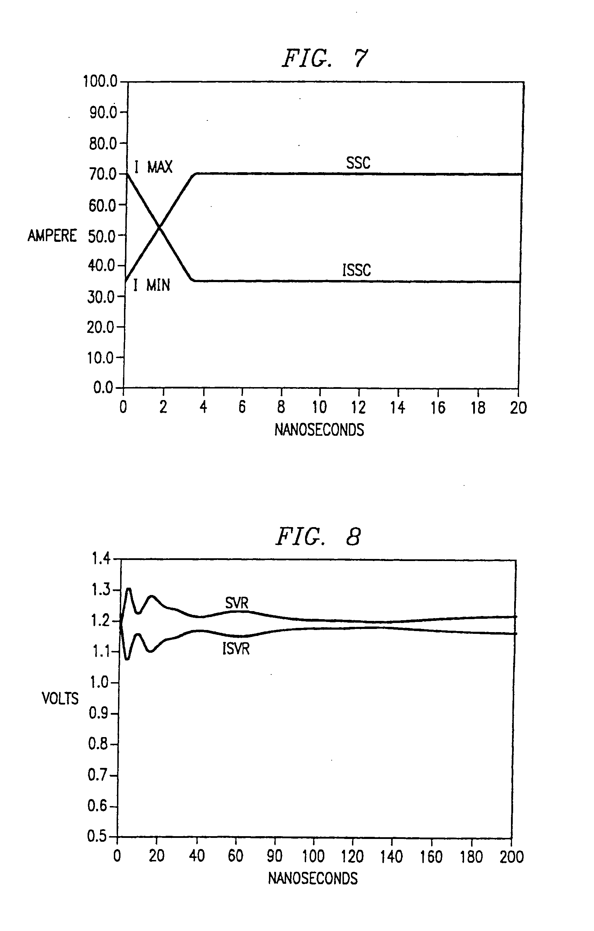

All maxima of the system response and all maxima of the inverse system response will be gathered by this special input waveform at the time moment T. Constructed in this manner, each positive transition starting at time moment $(T - t_i)$ will cause a maximum of the transient response exactly at the time moment T. Each negative transition will cause a maximum of the inverse transient response at the time moment T. All maxima of the system response and all maxima of the inverse system response are therefore accumulated at the time moment T. In effect, the system response is flipped with respect to the time axis so that the times used to build the worst case stimulus are in the reverse order of the points of maxima and minima of the system step response, as shown in FIGURE 4B. A plot illustrating an exemplary excitation input current that corresponds to the voltage response in FIGURES 3 through 5 is shown in FIGURE 6. It may be seen that all maximum and minimum points are shifted so that they occur at the chosen time T. Therefore, in this example,

$$V(0) = V_0 - V_1 + V_2 - V_3,$$

or expressed generally:

$$Vmax = \sum_i^\infty Vmax_i - \sum_i^\infty Vmin_i,$$

$$Vmin = \sum_i^\infty Vmin_i - \sum_i^\infty Vmax_i$$

where

$$\sum_i^\infty Vmax_i$$

is the sum of all maxima of the function V(t) at $0 \leq t < \infty$, and

$$\sum_i^\infty Vmin_i$$

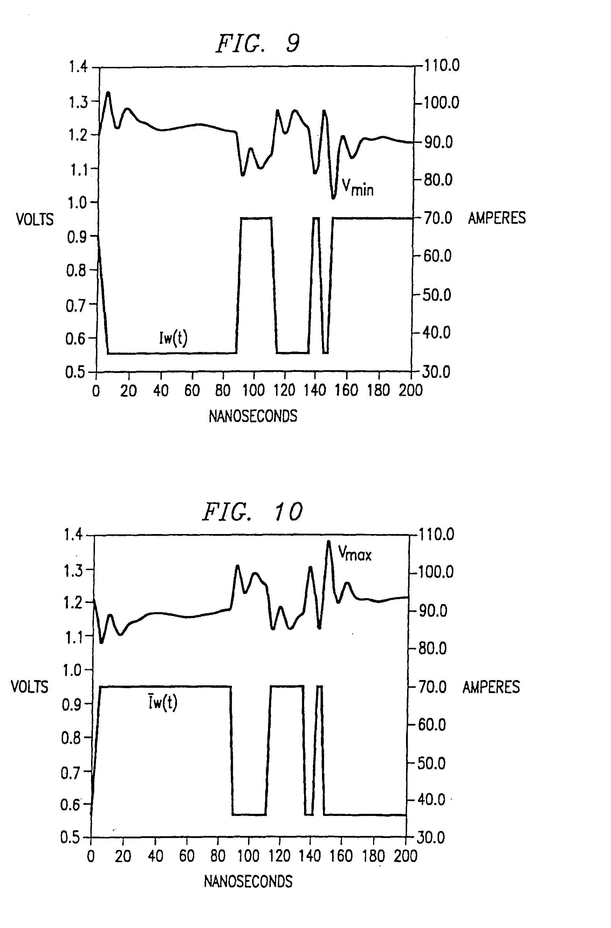

is the sum of all minima of the function V(t) at $0 \leq t < \infty$.
As shown in FIGURE 7, a plot of an exemplary standard stimulus current and inverse standard stimulus current plotted by a circuit simulation software. FIGURE 8 is a plot of an exemplary standard voltage response and inverse standard voltage response, V(t). FIGURE 9 is a plot of an exemplary worst case minimum voltage and stimulus current according to the teachings of the present invention, and FIGURE 10 is a plot of an exemplary worst case maximum voltage and stimulus current according to the teachings of the present invention.
In conventional system testing and modeling, the typical choice of step function or meander wave with constant pulse repetition frequency do not induce the worst case system response. The method of the present invention is operable to determine the input excitation that would induce the maximum and minimum response in the target system. In test conditions the stimulus input is maintained within its maximum and minimum bounds while the waveform is random.
Although the present invention has been described with respect to electrical or electronic systems, the present invention is also applicable to mechanical systems such as automotive suspension systems, for example, where it is of interest to subject the system to an input that would create the worst-case response to verify the system design and operations. For example, the unit step input for a suspension system may be a bump of a predetermined height, such as five inches. The system response would be the amount of deviation from neutral in the upward and downward directions, and the times $t_i$ for maximum deviation in the upward direction and times $t_j$ for maximum deviation in the downward direction. It may be seen that the present invention may be modified and adapted to the testing and modeling of other types of systems either in a laboratory or in a simulated model.

The present invention may be embodied in a test system or simulation system that first determines the worst-case excitation input of the target system, and then subjects the target system to the worst-case excitation input. Again, the system may test the actual system or simulate the testing with a model of the system. Such a system is likely to be microprocessor-based and have an interface that is operable to supply the excitation input to the system being tested and to receive output from the system.

**Claims**

1. A method (12), comprising:

exciting a system (10) with a standard input having predetermined maximum and minimum input values (14);
selecting time points $t_i$ and $t_j$ in a system response having a plurality of maximum response values at time points $t_i$ and a plurality of minimum response values at time points $t_j$ (16); and
generating a maximum worst-case excitation input having a positive transition from the predetermined minimum input value to the predetermined maximum input value at each time point $(T - t_i)$, and a negative transition from the predetermined maximum input value to the predetermined minimum input value at each time point (T - $t_j$) (18, 20).

2. The method, as set forth in claim 1, further comprising generating a minimum worst-case excitation input having a negative transition from the predetermined minimum input value to the predetermined maximum input value at each time point (T - $t_i$), and a positive transition from the predetermined maximum input value to the predetermined minimum input value at each time point (T - $t_j$) (18, 22).

3. The method, as set forth in claim 1, wherein exciting a system comprises exciting the system with a unit step current input (14).

4. The method, as set forth in claim 1, wherein selecting time points comprises selecting any two adjacent maximum response values with a minimum response value therebetween.

5. The method, as set forth in claim 2, further comprising exciting the system using at least one of the maximum and minimum worst-case excitation input.

6. The method, as set forth in claim 2, further comprising exciting a simulation model of the system using at least one of the maximum and minimum worst-case excitation input.

7. A system comprising:

   computer-executable medium having encoded therein a process operable to:

   excite a system with a step input having predetermined maximum and minimum input values (14);
   select time points $t_i$ and $t_j$ in a system response having a plurality of maximum response values at time points $t_i$ and a plurality of minimum response values at time points $t_j$ (16); and
   generate a maximum worst-case excitation input having a positive transition from the predetermined minimum input value to the predetermined maximum input value at each time point (T - $t_i$), and a negative transition from the predetermined maximum input value to the predetermined minimum input value at each time point (T - $t_j$) (18, 20).

8. The system, as set forth in claim 7, wherein the process is further operable to generate a minimum worst-case excitation input having a negative transition from the predetermined minimum input value to the predetermined maximum input value at each time point (T - $t_i$), and a positive transition from the predetermined maximum input value to the predetermined minimum input value at each time point (T - $t_j$) (18, 22).

9. The system, as set forth in claim 7, wherein the process is further operable to excite the system with a unit step current input (14).

10. The system, as set forth in claim 7, wherein the process is further operable to select any two adjacent maximum response values with a minimum response value therebetween.

## FIG. 2

12 ─◯ METHOD

14 ─ EXCITE SYSTEM WITH STEP WAVEFORM

16 ─ MEASURE TIME = $t_0$ TO $t_n$ FOR ALL MAX AND MIN STEP RESPONSE

18 ─ CHOOSE T AND CALCULATE $(T-t_0)$, $(T-t_1)$, $(T-t_2)$...

20 ─ BUILD STIMULUS FOR MAXIMUM SYSTEM RESPONSE FROM MAX AND MIN STEP RESPONSES

22 ─ BUILD STIMULUS FOR MINIMUM SYSTEM RESPONSE FROM MIN AND MAX STEP RESPONSES

24 ─◯ END

## FIG. 1

$I_w(t)$ ──→ SYSTEM ── $V(t)$

10

## FIG. 3A

$I_{High}$

$I_{Low}$

0 ── t

## FIG. 3B

$V_0$

$V_2$

0 $t_0$ $t_1$ $t_2$ $t_3$ ── t

$V_1$

$V_3$

FIG. 4A

FIG. 4B

FIG. 5A

FIG. 5B

FIG. 5C

FIG. 5D

FIG. 5E

FIG. 6

FIG. 7

FIG. 8

FIG. 9

FIG. 10